(19) Europäisches Patentamt
European Patent Office
Office européen des brevets

(11) **EP 0 525 349 B1**

(12) **EUROPÄISCHE PATENTSCHRIFT**

(45) Veröffentlichungstag und Bekanntmachung des Hinweises auf die Patenterteilung:
**10.03.1999 Patentblatt 1999/10**

(51) Int Cl.$^6$: **H03M 7/40**

(21) Anmeldenummer: **92110013.7**

(22) Anmeldetag: **13.06.1992**

(54) **Einrichtung zur redunanzvermindernden Codierung**

Device for redundancy reduction encoding

Dispositif pour codage réduisant la redondance

(84) Benannte Vertragsstaaten:
**DE FR GB**

(30) Priorität: **04.07.1991 DE 4122169**

(43) Veröffentlichungstag der Anmeldung:
**03.02.1993 Patentblatt 1993/05**

(73) Patentinhaber: **ROBERT BOSCH GMBH**
**70442 Stuttgart (DE)**

(72) Erfinder: **Lappe, Dirk**
**W-3200 Hildesheim (DE)**

(56) Entgegenhaltungen:
**EP-A- 0 350 439**

- **IBM JOURNAL OF RESEARCH AND DEVELOPMENT, Bd.28, Nr.2, März 1984, NEW YORK Seiten 135 - 149 LANGDON JR 'an introduction to arithmetic coding'**

**Beschreibung**

Die Erfindung geht aus von einer Einrichtung nach der Gattung des Hauptanspruchs.

Zur datenreduzierenden Codierung von Nachrichten ist eine Berücksichtigung der Auftrittswahrscheinlichkeit einzelner zu übertragender Symbole innerhalb einer vorgegebenen Menge von Symbolen bekannt. So wird beispielsweise bei einem als Huffman-Code bekanntgewordenen Code die Länge der die einzelnen Symbole darstellenden Codewörter in Abhängigkeit von der Auftrittswahrscheinlichkeit gewählt. Daraus ergibt sich beim Huffman-Code eine binäre Staffelung der bei der Codierung berücksichtigten Auftrittswahrscheinlichkeit, die nur ungefähr mit der jeweils vorhandenen Auftrittswahrscheinlichkeit übereinstimmt. Deshalb nähert sich beim Huffman-Code die übertragene Datenmenge erst bei langen Symbolfolgen der Entropie. Diese Voraussetzung ist jedoch bei vielen Anwendungen von datenreduzierenden Codierungen, beispielsweise bei der Übertragung von Videodaten zu Zwecken des Fernsehtelefons, nicht gegeben.

Ein weiteres bekanntes Verfahren, wie es in IBM Journal of Research and Development, Bd. 28, März 1984, S. 135-149, Langdon, Jr. "An introduction on arithmetic coding", dargestellt ist, welches die Auftrittswahrscheinlichkeit der Symbole bei der Codierung berücksichtigt, ist die arithmetische Codierung. Hierbei wird ein Intervall von 0,0 bis 1,0 erzeugt, das in Teilintervalle aufgeteilt wird, die den Auftrittswahrscheinlichkeiten der Symbole entsprechen. Berechnungsgrundlage der zu sendenden Codefolge sind die Auftrittswahrscheinlichkeiten und die kumulativen Wahrscheinlichkeiten. Die Codefolge ist dann der Anfangspunkt desjenigen Teilintervalls, in welches das zu sendende Symbol fällt. Mit jedem neu aufgetretenen Symbol wird das Teilintervall, in welches das vorangegangene Symbol fällt, als neues Intervall angenommen. Dieses wird bis zum Ende einer zu übertragenden Symbolfolge fortgesetzt. Gegenüber dem Huffman-Code steht der Vorteil, daß nicht ganzzahlige Codelängen für einzelne Codewörter entstehen, die an die jeweilige Auftrittswahrscheinlichkeit besser angepaßt sind.

Aufgabe der vorliegenden Erfindung ist es, Verbesserungen bezüglich der technischen Realisierung der bekannten Verfahren sowie bezüglich der Ausnutzung der statistischen Eigenschaften der zu übertragenden Nachricht anzugeben. Insbesondere wird bei einer Ausführungsform der Erfindung eine Verbesserung der arithmetischen Codierung angegeben, bei welcher die Codefolge wesentlich verkürzt wird.

Bei einer anderen Ausführungsform der Erfindung wird die Auftrittswahrscheinlichkeit jeweils eines Symbols dadurch genauer bestimmt, daß ein oder mehrere vorangegangene Symbole berücksichtigt werden.

Eine andere Ausgestaltung der Erfindung ermöglicht eine weitere Reduzierung der Datenmenge dadurch, daß bei der Codierung diejenigen Symbole aus einer vorgegebenen Menge von Symbolen, welche noch nicht aufgetreten waren, nicht berücksichtigt werden. Es werden ferner besondere Maßnahmen angegeben, um eine Übertragung der neu auftretenden Symbole sicherzustellen.

Die Erfindung beschäftigt sich ferner damit, daß mit Hilfe einer Einrichtung zur Codierung Symbole aus mehreren Quellen quasi gleichzeitig übertragen werden können.

Die Erfindung ist nicht auf die Codierung beschränkt, sondern bezieht sich auch auf die Decodierung der nach einer erfindungsgemäßen Codierung übertragenen Codefolgen. Die Erfindung kann zur datenreduzierten Übertragung verschiedener Signale, wie beispielsweise digitaler Videosignale oder digitaler Audiosignale, verwendet werden. Die Erfindung kann ferner mit Erfolg zur Übertragung von anderen Daten angewendet werden, beispielsweise zur Übertragung von Schriftzeichen.

Durch die in den Unteransprüchen aufgeführten Maßnahmen sind vorteilhafte Weiterbildungen und Verbesserungen der im Hauptanspruch angegebenen Erfindung möglich.

Ausführungsbeispiele der Erfindung sind in der Zeichnung anhand mehrerer Figuren dargestellt und in der nachfolgenden Beschreibung näher erläutert. Es zeigt:

Fig. 1  ein Blockschaltbild eines arithmetischen Coders gemäß der Erfindung,

Fig. 2  das Hauptintervall des arithmetischen Coders nach Fig. 1,

Fig. 3  eine schematische Darstellung der Codierung verschiedener Symbole,

Fig. 4  das Hauptintervall und die Codefolge nach einer Skalierung,

Fig. 5  ein Flußdiagramm eines Programms für einen zur Codierung dienenden Signalprozessor,

Fig. 6  ein Blockschaltbild eines arithmetischen Decoders,

Fig. 7  ein Blockschaltbild einer Einrichtung zur Bildcodierung mit einem arithmetischen Coder und weiteren redundanzvermindernden Maßnahmen,

Fig. 8  ein Flußdiagramm eines Programms zur Codierung von neu auftretenden Symbolen,

Fig. 9  eine Einrichtung zur statistischen Auswertung und

Fig. 10    eine Einrichtung zur Codierung von Symbolen verschiedener Quellen.

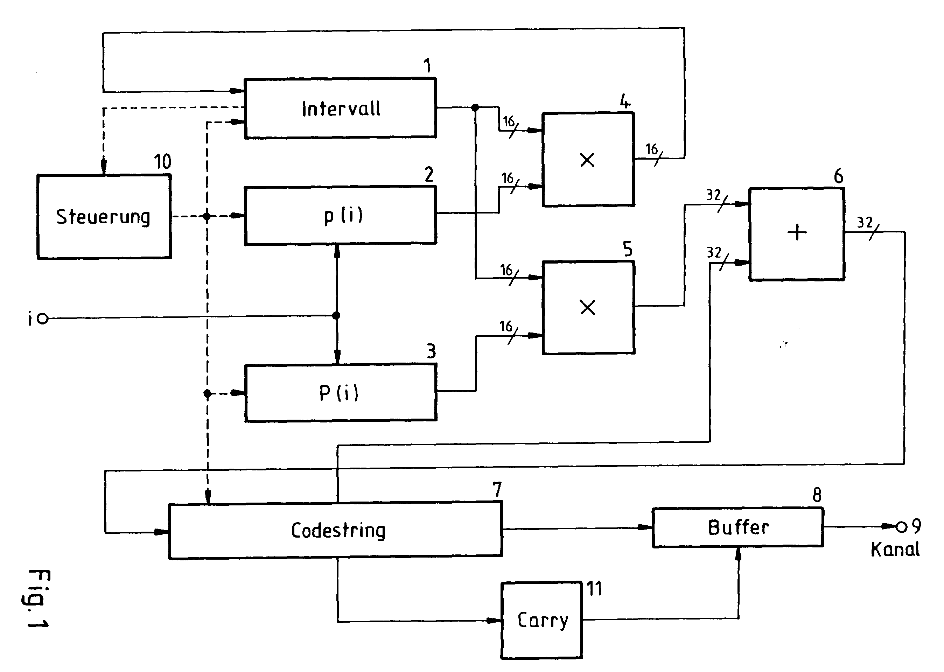

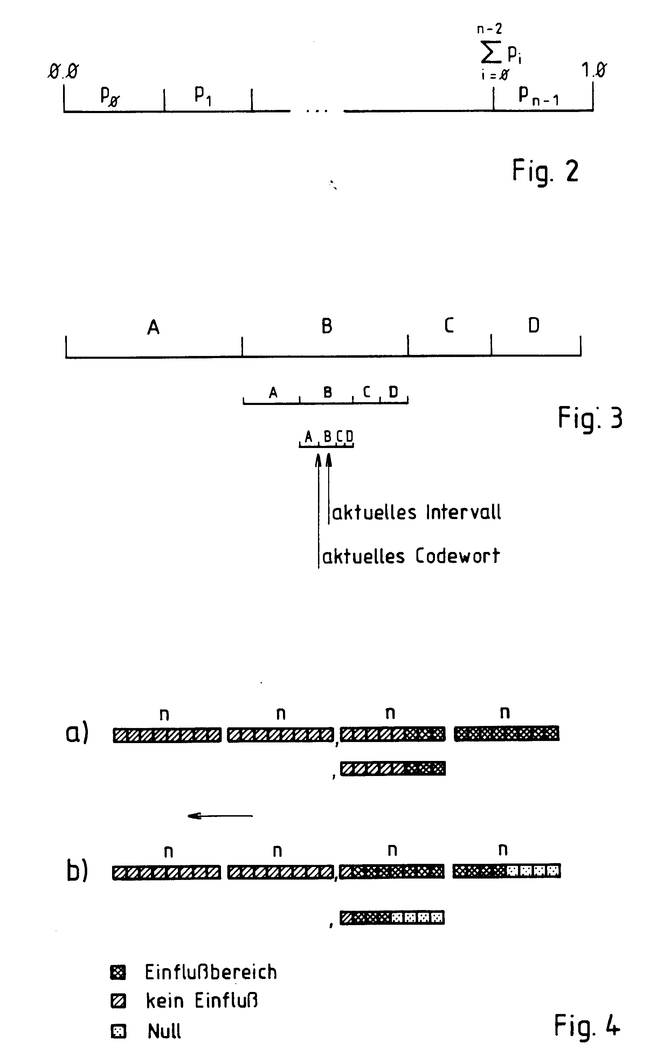

Fig. 1 zeigt ein Blockschaltbild eines arithmetischen Coders gemäß der Erfindung. Ein derartiger Coder kann, wie im Blockschaltbild dargestellt, mit einer Schaltung realisiert werden, welche aus einzelnen Bausteinen besteht, nämlich Registern und Rechenschaltungen. Es ist jedoch auch eine Realisierung mit Hilfe eines oder mehrerer entsprechend programmierter Signalprozessoren möglich. Die einzelnen Baugruppen des Blockschaltbilds nach Fig. 1 werden im folgenden nur kurz beschrieben. Die Erläuterung ihrer eigentlichen Funktion erfolgt danach anhand der Figuren 2 bis 4 sowie der in der zugehörigen Beschreibung angegebenen Formeln.

Der Coder gemäß Fig. 1 enthält drei Register 1, 2, 3 zur Speicherung eines Intervalls, einer Wahrscheinlichkeit $p(i)$ und einer kumulativen Wahrscheinlichkeit $P(i)$. Die in den Registern gespeicherten Werte sind bei dem Ausführungsbeispiel jeweils 16 Bit breit und werden zwei Multiplizierern 4, 5 zugeführt, wobei das Ergebnis des Multiplizierers 4 mit einer Breite von 16 Bit - also entsprechend gerundet - wieder in das Intervallregister 1 eingeschrieben wird.

Das Ergebnis des Multiplizierers 5 wird mit einer Breite von 32 Bit einem Addierer 6 zugeführt, dem ferner der Inhalt eines weiteren Registers 7 zugeleitet wird. Nach Addition des Inhalts des Registers 7 zu dem Ausgangswert des Multiplizierers 5 wird das Ergebnis als neuer Codestring in das Register 7 eingeschrieben.

Ein sich aufgrund dieser Addition nicht mehr verändernder Teil des Codestrings wird jeweils in einen Buffer 8 eingeschrieben, von dessen Ausgang 9 die codierten Signale übertragen werden. Die zeitliche Steuerung der Schaltung nach Fig. 1, insbesondere die Taktung der Register, wird von einer Steuerschaltung 10 durchgeführt.

Wie in Fig. 2 dargestellt, wird für die arithmetische Codierung (AC) ein Intervall von 0,0 bis 1,0 erzeugt und in Teilintervalle aufgeteilt, die den Auftrittswahrscheinlichkeiten oder den bedingten Wahrscheinlichkeiten der Symbole oder den Verbundwahrscheinlichkeiten mehrerer Symbole entsprechen. Die Aufteilung erfolgt nach den Auftrittswahrscheinlichkeiten $p_i$ der Symbole. Ferner werden zur Berechnung des jeweils eine Symbolfolge darstellenden Codestrings C die kumulativen Wahrscheinlichkeiten $P_i = \Sigma p_i$ verwendet. Damit ergibt sich der Codestring C als Anfangspunkt des Teilintervalls im Hauptintervall I zu $C_{i+1} = C_i + I_i \cdot P_{i+1}$.

Mit jedem neu aufgetretenen Symbol wird das Teilintervall, auf welches das Symbol zeigt, als neues Hauptintervall I angenommen und entsprechend skaliert.

$$I_{i+1} = I_i \cdot p_i$$

Das ursprüngliche Hauptintervall wird in Abhängigkeit von den zu sendenden Symbolen jeweils in ein Teilintervall überführt und dieses Intervall entsprechend den Wahrscheinlichkeiten neu unterteilt.

Die Codierung einer Symbolfolge ist beispielhaft in Fig. 3 angegeben. Der Codestring, das heißt der Anfangspunkt des Intervalls, wird übertragen und gibt eindeutig die bisher aufgetretenen Symbole in Folge wieder. Bei dem in Fig. 3 dargestellten Beispiel wird also ein Codestring übertragen (aktuelles Codewort), der die Symbolfolge "BBB" darstellt.

An dieser Stelle entsteht der eigentliche Gewinn des arithmetischen Codes beispielsweise gegenüber dem Huffman-Code. Im Gegensatz zu diesem können bezogen auf einzelne Symbole unganzzahlige Codelängen entstehen. Dabei ist zu beobachten, daß nicht immer nach der Codierung jedes Symbols Bits aus dem Einflußbereich des Codestrings herausfallen und übertragen werden. Die Information wird innerhalb des Codestrings festgehalten und erst in Kombination mit weiteren zu übertragenen codierten Symbolen auf den Kanal geschickt.

Durch die fortlaufende Bildung neuer Hauptintervalle, nämlich durch die Multiplikation von Wahrscheinlichkeiten, entstehen Fließkommazahlen, welche die Genauigkeitsgrenzen des zu verwendenden Rechners überschreiten. Um sowohl den Codestring C als auch das Hauptintervall I innerhalb eines zulässigen Genauigkeitsbereichs zu halten, wird nach jeder Übergabe eines Symbols an den Coder der Code mit allen seinen Werten auf Skalierbarkeit untersucht.

Wird das Hauptintervall I vergrößert, können die momentanen Eigenschaften aller Variablen untereinander beibehalten werden, indem der Codestring C in gleichem Maße im Maßstab verändert wird. Die Anzahl t der führenden näheren Nullen nach dem Komma des Hauptintervalls I gibt die Positionen derjenigen Bit wieder, die bei der nächsten Operation den Codestring nicht mehr beeinflussen können (Einflußbereich). Hauptintervall und Codestring können also vergrößert und damit wieder in einen genaueren Bereich zurückgeführt werden. Die Bit, die nicht mehr im Einflußbereich liegen, können ausgetaktet werden. Das Hauptintervall I und der Codestring C werden um den Faktor $2^t$ vergrößert. Dieses entspricht jeweils einem Linksshift um t bei beiden Werten.

Eine Begrenzung der kumulativen Wahrscheinlichkeit $P_i$ und der Wahrscheinlichkeit $p_i$ und des Ergebnisses $I_i \cdot P_i$ auf n Bit bei einem 2n langen Codestring C ist für eine fehlerfreie Codierung notwendig. Bei bekannten Codes, beispielsweise G.G. Langdon, Jr., and J.J. Rissanen, "Compression of Black-White Images with Arithmetic Coding," IEEE Trans. Commun. COM-29, 858-867 (1981), verringert sich dadurch der Gewinn des Codes, da eine volle Ausnutzung der Intervallbreiten nicht mehr möglich ist. Eine vorteilhafte Ausführungsform der Erfindung zur Reduktion der Datenrate und zum Ausgleich dieser Verluste beruht darauf, daß die Codefolge durch jeden Wert innerhalb des letzten aktuellen Intervalls eindeutig bestimmt ist. Deshalb wird innerhalb des letzten aktuellen Hauptintervalls der Übertragungsfolge die binäre Permutation mit minimaler Bitzahl b ermittelt (mit b Bit quantisiert), die ebenfalls auf das Hauptintervall zeigt. Mit m als der ungekürzten Bitzahl und w() als einer Fließkommazahl gilt b≤m, C _ w(m Bit) _ w(b Bit) C + l und C C + l. Schon bei sehr kurzen Symbolfolgen geht auf diese Weise die Redundanz gegen 0.

Nach der Minimierung der Bitzahl ist es erforderlich, ein Codewort für das Ende des Codestrings (end of string = EOS) einzuführen, da der Codestring nach Decodierung des letzten Symbols nicht mehr 0 wird. Die Datenrate verändert sich durch dieses eine Wort nur unwesentlich und die Einführung von EOS-Codewörtern im Quellencoder ist für eine Trennung der einzelnen Übertragungsblöcke im Quellendecoder ohnehin notwendig.

Aus dem Carry-Buffer der Länge 2n wird alle n Takte die obere Hälfte als n-Bit-Block ausgetaktet. Als zusätzliche Sicherheitsmaßnahme wird bei Auftreten einer n langen 1-Folge eine "Stopp-0" gesendet, die im Decoder die gleiche Wertigkeit wie die vorhergehende 1 hat.

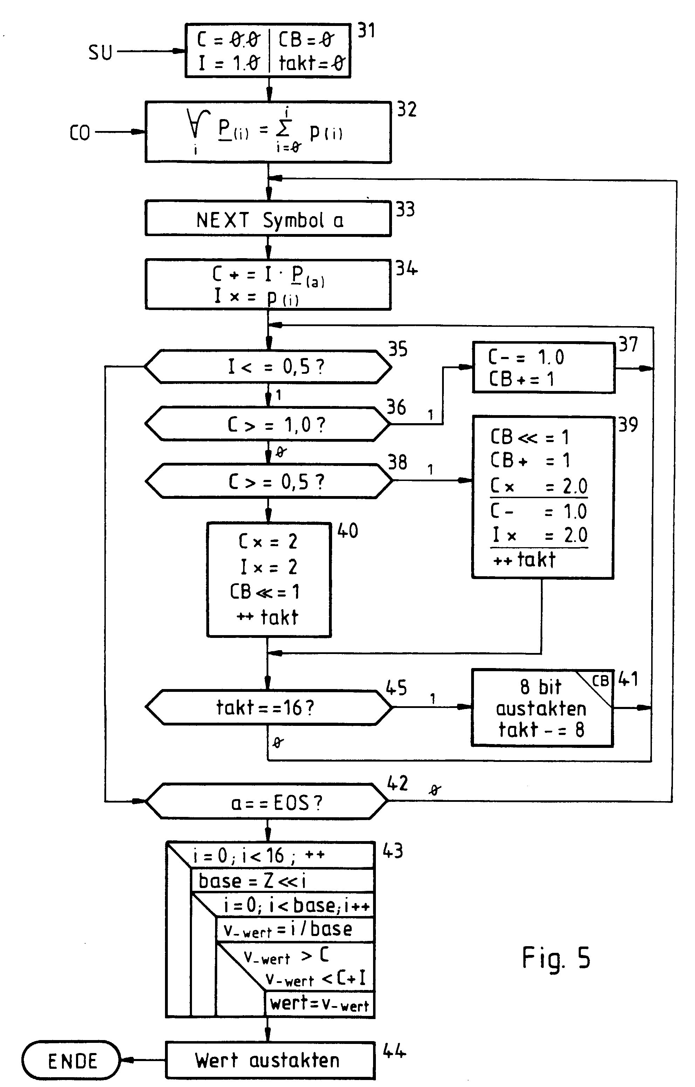

Fig. 4 zeigt das Hauptintervall l und den Codestring C mit Carry-Buffer (a) vor und (b) nach dem Takten. Dabei sind diejenigen Bits, welche nicht mehr im Einflußbereich liegen, also nicht mehr durch neu zu übertragende Symbole geändert werden können, einfach schraffiert, die Bits innerhalb des Einflußbereichs doppelt schraffiert, während Nullen gepunktet sind.

Fig. 5 zeigt ein Flußdiagramm eines Programms für einen zur Codierung dienenden Signalprozessor. Beim Start 31 des Programms werden die Variablen C, CB, l sowie der Takt T auf 0 gesetzt. Im Programmteil 32 wird aus einer später noch zu erläuternden Statistikeinheit SU die Wahrscheinlichkeiten p(i) aller "bekannten", das heißt bisher aufgetretenen Symbole, übernommen und dazu die kumulativen Wahrscheinlichkeiten P(i) berechnet. Bei 33 wird das erste Symbol eingelesen. Anschließend wird im Programmteil 34 der Codestring C um l·P(i) erhöht, während das Intervall l mit der Wahrscheinlichkeit p(i) multipliziert wird.

Bei 35 verzweigt sich das Programm in Abhängigkeit davon, ob das Intervall <0,5 bzw. das MSB von l eine Null ist. Ist dieses der Fall, können l und C skaliert werden. 36 stellt dazu fest, ob bereits ein Carry aufgetreten ist und 37 setzt in diesem Fall in C das MSB zu Null und addiert eine Eins in den Carry-Buffer CB.

Abhängig von der Abfrage 38 überträgt entweder 39 eine Eins oder 40 eine Null in den Carry-Buffer. Ein Zähler 'takt' kontrolliert in 45, ob der obere Bereich des Carry-Buffers ausgetaktet werden kann (16 Bit, alle 16 Takte durch Einheit 41).

42 entscheidet anhand des aktuellen Symbols, ob das Ende des Codestrings erreicht ist, oder ob weitere Symbole zu codieren sind. Zu Ende der Codierung sucht Einheit 43 diejenige Bitpermutation, die noch innerhalb des Intervalls liegt und dabei eine minimale Bitzahl hat. Zuletzt taktet 44 die letzten Bits aus.

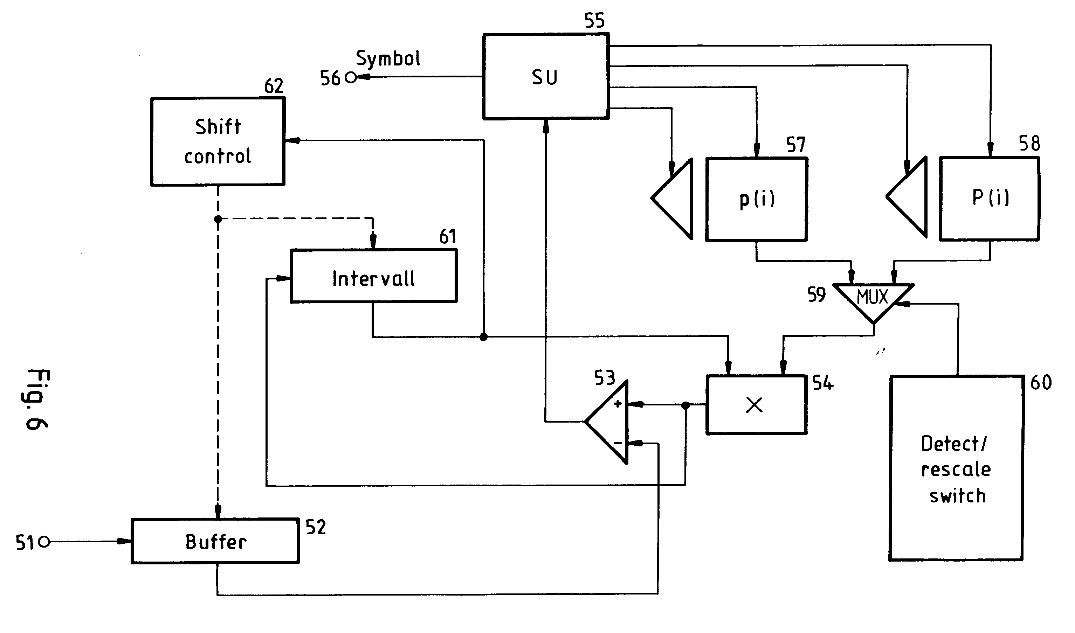

Fig. 6 zeigt das Blockdiagramm eines Decoders, mit welchem nach Codierung mit einem Coder nach Fig. 1 und einer Übertragung eine Decodierung erfolgt. Der Eingang 51 des Decoders ist mit dem Übertragungskanal verbunden. Die vom Übertragungskanal ankommenden Signale werden zunächst in einen Buffer 52 eingeschrieben. Ein Subtrahierer 53 subtrahiert die jeweils im Buffer befindlichen Werte vom Ausgangswert eines Multiplizierers 54. Das Ergebnis wird einer Statistik Einheit 55 zugeführt und kann von deren Ausgang 56 als decodiertes Symbol entnommen werden. Die Statistik Einheit ist ferner mit zwei Speichern 57, 58 für die Wahrscheinlichkeit p(i) und die kumulative Wahrscheinlichkeit P(i) verbunden. Die Ausgänge der Speicher 57 und 58 sind mit einem Multiplexer 59 verbunden, der von einem "detect rescale switch" gesteuert wird. Dieser ist eine Einheit, die zwischem den Modi Codestring modifizieren und Intervall modifizieren umschaltet. Ein Register 61 ist für das jeweils gültige Intervall vorgesehen. Eine Steuereinheit 62 steuert die Verschiebung der Bits in dem Buffer 52 und dem Register 61.

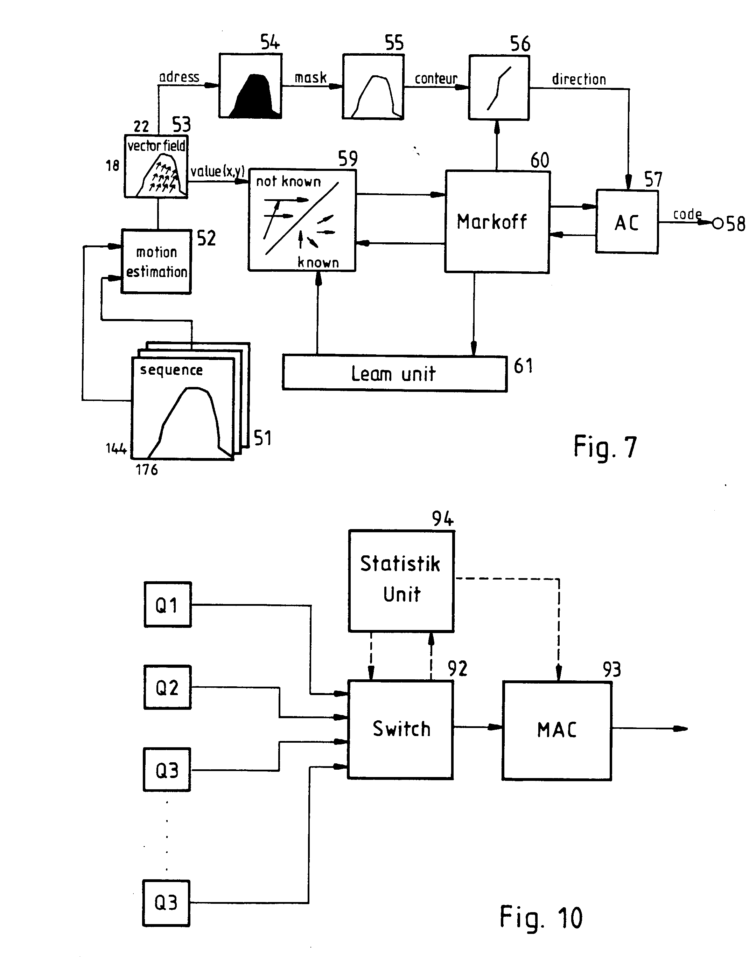

Der in Fig. 7 als Beispiel dargestellte Coder ist für eine redundanzvermindernde Codierung eines Vektorfeldes vorgesehen, das den Bewegungsinhalt eines zu übertragenden Bildes darstellt. Eine bevorzugte Anwendung eines derartigen Coders ist ein Fernsehtelefon.

Um eine Bewegungsschätzung durchführen zu können, werden bei 51 zunächst zwei aufeinander folgende Bilder von beispielsweise 144 x 176 Bildelementen in einem geeigneten Speicher abgelegt. Die Bewegungsschätzung erfolgt mit einem an sich bekannten Bewegungsschätzer 52 durch Vergleich aufeinander folgender Bilder, wobei die Verschiebungen einzelner Blöcke des Bildes ermittelt werden. Bei dem dargestellten Beispiel bilden jeweils 8 x 8 Bildelemente einen Block. Für jeden dieser Blöcke wird ein Bewegungsvektor ermittelt, dessen Größe und Richtung die Bewegung beschreibt. Alle Bewegungsvektoren bilden ein Vektorfeld 53, das in redundanzvermindernder Weise codiert wird.

Um die Adresse der Vektoren bitsparend zu codieren, repräsentiert in 54 genau ein Pixel einer binären Maske einen Vektor. Bei 55 wird die entsprechende Kontur berechnet und bei 56 entsprechende Richtungsvektoren der Kontur ermittelt und einem arithmetischen Coder 57 zugeführt.

Bei den vorliegenden Markoff-Prozessen höherer Ordnung, insbesondere bei Quellen mit einem großen Symbolvorrat, kann es vorkommen, daß Symbole über längere Zeit nicht auftreten. Ein hoher Codiergewinn kann erzielt werden, wenn diese Symbole nicht mit in die Statistik aufgenommen werden. Um einen Widerspruch mit dem Satz der totalen Wahrscheinlichkeit zu vermeiden, werden diese Symbole zu einer Menge von "unbekannten Symbolen" und damit zu einem Codewort zusammengefaßt. Nach Auftreten eines solchen Symbols können die entsprechenden (n-1)-Werte anhand der Verteilungsdichtefunktion eines Markoff-0-Prozesses codiert werden. Der Codegewinn verringert sich dadurch nur unerheblich. Tritt ein solches Symbol auf, wird es durch einen Selbstlernprozeß in die Verteilungsdichte aufgenommen und steht für die Zukunft als Codewort zur Verfügung.

Deshalb werden zur Codierung des Vektors selbst die beiden Komponenten X, Y bei 59 zunächst daraufhin untersucht, ob gleiche Vektoren bereits aufgetreten sind und somit dem arithmetischen Coder 57 bereits zugeführt wurden. Die bekannten Symbole werden dann einer Einheit 60 zur Durchführung von Markoff-Prozessen höherer Ordnung übergeben. Beim erstmaligen Auftreten eines Symbols wird ein für alle erstmalig auftretenden Symbole gleiches Symbol codiert und das erstmalig aufgetrete Symbol nach dem Codestring direkt gesendet.

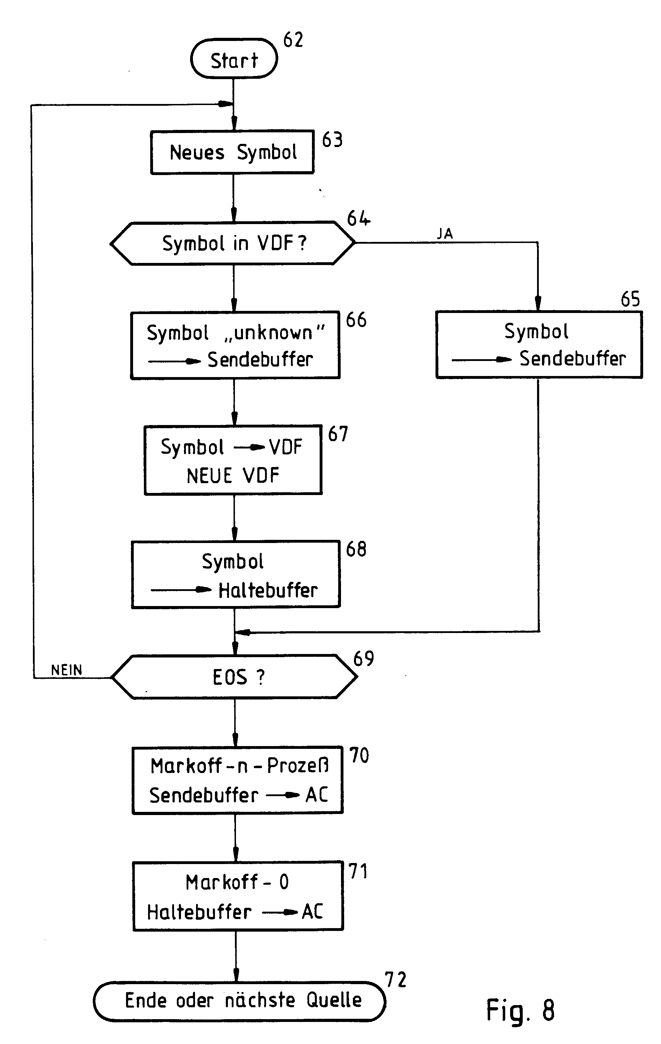

Der Selbstlernprozeß kann in einer Selbstlerneinheit 61 anhand eines in Fig. 8 dargestellten Programms durchgeführt werden. Nach dem Start des Programms bei 62 wird zunächst bei 63 ein neues Symbol eingelesen. Bei 64 verzweigt sich das Programm in Abhängigkeit davon, ob das Symbol bereits in der Verteilungsdichtefunktion berücksichtigt wurde. Ist dieses der Fall, so wird bei 65 das Symbol in einen Sende-Buffer eingeschrieben, von dem es später dem arithmetischen Coder übergeben wird. Ist das Symbol jedoch noch nicht in der Verteilungsdichtefunktion berücksichtigt, wird das Symbol "unbekannt" bei 66 in den Sende-Buffer eingeschrieben und bei 67 eine neue Verteilungsdichtefunktion unter Berücksichtigung des neuen Symbols berechnet. Danach wird im Programmteil 68 das neue Symbol in einen Halte-Buffer eingeschrieben.

Im Anschluß daran verzweigt sich bei 69 das Programm in Abhängigkeit davon, ob das Ende des Codestrings erreicht ist, das heißt, ob alle gemeinsam zu codierenden Symbole codiert sind. Solange dieses noch nicht der Fall ist, wird das Programm, beginnend mit dem Programmteil 63, durch Einlesen eines neuen Symbols wiederholt. Sind jedoch alle Symbole verarbeitet, wird bei 70 der Inhalt des Sende-Buffers nach Durchführung des Markoff-n-Prozesses aus dem Sende-Buffer in den arithmetischen Coder AC übertragen. Danach wird unter Anwendung eines Markoff-0-Prozesses der Inhalt des Halte-Buffers in den arithmetischen Coder AC übertragen. Bei 72 wird das Programm beendet oder auf die nächste Quelle (Fig. 10) angewendet.

Um die Korrelation einzelner Symbole untereinander und damit die Redundanz des Codes auszunutzen, ist es sinnvoll, von der Annahme statistisch unabhängiger Ereignisse (Markoff-Prozeß 0. Ordnung) auf Markoff-Prozesse höherer Ordnung überzugehen. Allgemein können für einen Markoff-Prozeß n. Ordnung und für eine Quelle von k Symbolen $z = k^{n+1}$ verschiedene Ereignisse auftreten. Dabei kann entweder die Verbundwahrscheinlichkeit oder die bedingte Wahrscheinlichkeit übertragen werden. Bei der Übertragung der Verbundwahrscheinlichkeit entsteht ein Markoff-Prozeß (n-1). Ordnung, in dem jeweils n Symbole zusammengefaßt und übertragen werden. Die Gesamtzahl der Symbole steigt dabei quadratisch und die Beziehung p(xly)<p(y)wird nur indirekt ausgenutzt.

Bei der Übertragung der bedingten Wahrscheinlichkeit wird abhängig von den letzten n Symbolen des Markoff-Prozesses n. Ordnung eine entsprechende Verteilungsdichtefunktion für das zu codierende Symbol angewendet. Hierbei wird direkt die Wahrscheinlichkeit p(xly)übertragen. Die Redundanz vermindert sich entsprechend $R = n \cdot H(X_0) - H(X_0 \, IX_1, ..., X_n)$. Dabei ist H die Entropie mit den Symbolen $(X_0, ... X_n)$ als Zufallsvariable.

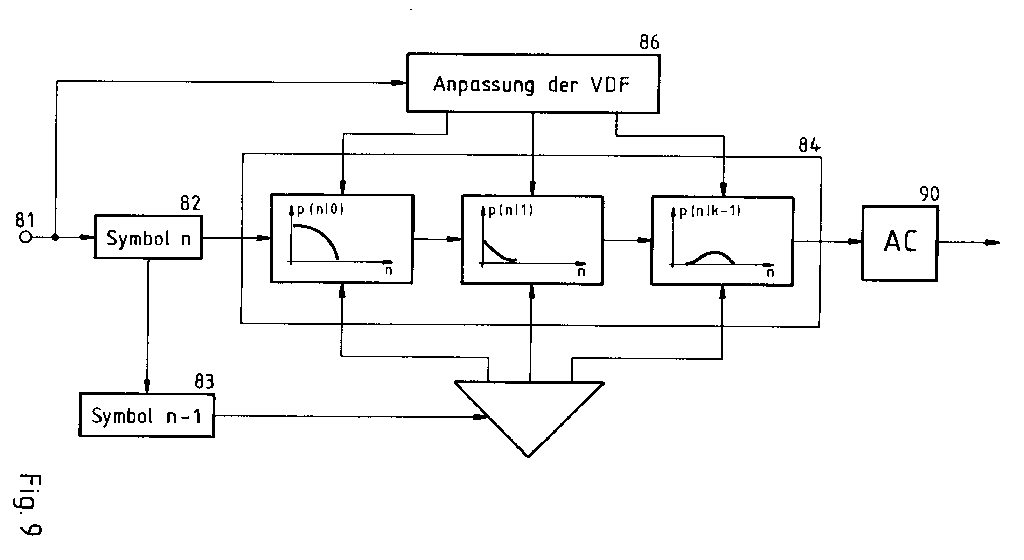

Bei dem im folgenden anhand von Fig. 9 beschriebenen Ausführungsbeispiel erfolgt eine Übertragung der bedingten Wahrscheinlichkeit mit einem Markoff-Prozeß erster Ordnung. Dazu werden die zu übertragenen Symbole über einen Eingang 81 zugeführt und in einem ersten Register 82 zwischengespeichert. Nach jedem neuen Symbol n wird das letzte Symbol n-1 in das zweite Register 83 weitergeschoben. Abhängig von Register 83 wird die gültige Tabelle 84 angesteuert und dieser Tabelle die bedingte Wahrscheinlichkeit (p(n/n-1) entnommen. Diese Wahrscheinlichkeit wird der arithmetischen Codierung 90 übergeben. Einheit 86 modifiziert, wie bereits beschrieben, die ausgewählte Tabelle.

Durch die leichte Anpassungsfähigkeit kann die erfindungsgemäße Einrichtung alle Entropie-Codierungen durchführen. Es ist lediglich erforderlich, dem Multi-Symbol-arithmetischen-Coder (MAC) die jeweils aktuelle Statistik vor der Codierung zu übergeben. Damit kann ein Coder auch zur quasi gleichzeitigen Codierung von Signalen mehrerer Quellen dienen.

Ein Beispiel dafür ist in Fig. 10 angegeben, wobei Quellen Q1 bis Qn über eine Umschalteinrichtung 92 mit einem Multi-Symbol-arithmetischen-Coder 93 verbunden sind. Eine Statistik-Einheit 94 ist mit der Umschalteinrichtung 92 und dem Coder 93 verbunden und ermittelt, speichert und wendet die für die jeweilige Quelle gültige Statistik an. Dabei können die Quellen völlig unabhängig voneinander, beispielsweise mehrere Sprachkanäle, sein oder verschiedene bei der Bildcodierung auftretende Signale abgeben, wie beispielsweise Bewegungssignale, Leuchtdichtesignale, Farbsignale.

**Patentansprüche**

1. Verfahren zur redundanzvermindernden Codierung, wobei von einer Menge zur Codierung vorgesehener Symbole solche mit größerer Auftrittswahrscheinlichkeit mit kürzeren Codeworten als solche mit geringer Auftrittswahrscheinlichkeit codiert werden, wobei eine Zahl zeitlich nacheinander auftretender Symbole eine Signalfolge bildet, so daß ein Intervall aus Teilintervallen gebildet wird, welche die Auftrittswahrscheinlichkeiten der einzelnen Symbole darstellen, und wobei geprüft wird, in welches Teilintervall das jeweils zu codierende Symbol fällt, wobei der Anfangspunkt des Teilintervalls, in das das jeweils zu codierende Symbol fällt, eine Codefolge bildet, wobei von Symbol zu Symbol das Teilintervall, in welches das Symbol fällt, als Hauptintervall für das folgende Symbol angenommen und die mit dem letzten Symbol entstehende Codefolge übertragen wird, dadurch gekennzeichnet, daß die durch die Codierung der gesamten Symbol folge entstehende Codefolge einen Wert aufweist, der mit möglichst wenig Binärstellen in das zuletzt ermittelte Teilintervall fällt.

2. Verfahren nach Anspruch 1, dadurch gekennzeichnet, daß beim Eingang eines Symbols die Codefolge mit allen ihren Werten auf Skalierbarkeit untersucht wird und daß zutreffendenfalls sowohl das jeweils gültige Intervall als auch die Codefolge im gleichen Maßstab verändert werden.

3. Verfahren nach Anspruch 1 oder 2, dadurch gekennzeichnet, daß diejenigen Binärstellen nach der Codefolge, die durch eine Skalierung nicht mehr beeinflußt werden können, ausgegeben werden.

4. Verfahren nach einem der Ansporüche 1 bis 3, dadurch gekennzeichnet, daß innerhalb des zuletzt ermittelten Teilintervalls diejenige binäre Permutation mit minimaler Binärstellenzahl ermittelt wird, die innerhalb des Intervalls liegt.

5. Verfahren nach den Ansprüchen 1 bis 4, dadurch gekennzeichnet, daß die Codefolge durch ein Endzeichen abgeschlossen wird.

6. Verfahren nach den Ansprüchen 1 bis 5, dadurch gekennzeichnet, daß durch statistische Auswertung der zu codierenden Symbole deren Auftrittswahrscheinlichkeiten ermittelt und damit die Teilintervalle gesteuert werden.

7. Verfahren nach den Ansprüchen 1 bis 6, dadurch gekennzeichnet, daß bei der statistischen Auswertung außer der einfachen Auftrittswahrscheinlichkeit die Verbundwahrscheinlichkeit berücksichtigt wird.

8. Verfahren zur redundanzvermindernden Codierung von Daten, wobei von einer Menge zur Codierung vorgesehener Symbole solche mit größerer Auftrittswahrscheinlichkeit mit kürzeren Codeworten als solche mit geringerer Auftrittswahrscheinlichkeit codiert werden, dadurch gekennzeichnet, daß bei der Festlegung der Teilintervalle Symbole, die zwar zur Menge der zur Codierung vorgesehenen Symbole gehören, jedoch innerhalb eines zu betrachtenden Zeitraums nicht aufgetreten sind, nicht berücksichtigt werden, daß bei erstmaligem Auftreten eines Symbols ein für alle neu auftretenden Symbole gleiches Ersatzsymbol codiert wird und daß im Anschluß an die Codefolge eine das neu auftretende Symbol darstellende Codefolge erzeugt wird.

9. Verfahren nach Anspruch 1, dadurch gekennzeichnet, daß einer Einrichtung zur Codierung über einen Multiplexer Symbole aus mehreren Quellen zuführbar sind und daß eine Einrichtung zur statistischen Auswertung der Symbole an die Einrichtung zur Codierung Auftrittswahrscheinlichkeiten der Symbole jeweils einer Quelle liefert.

## Claims

1. Method for redundancy-reduction coding, wherein, of a set of symbols provided for coding, those with a higher probability of occurrence are coded with shorter code words than those with a lower probability of occurrence, a number of symbols occurring successively in time forming a signal sequence so that an interval of part-intervals is formed which represent the probabilities of occurrence of the individual symbols, and wherein a check is made of the part-interval into which the symbol to be coded in each case falls, wherein the starting point of the part-interval into which the symbol to be coded in each case falls forms a code sequence, wherein the part-interval into which the symbol falls is assumed as main interval for the subsequent symbol from symbol to symbol and the code sequence produced with the last symbol is transmitted, characterized in that the code sequence produced by the coding of the entire symbol sequence exhibits a value which falls into the last-determined part-interval with the fewest possible binary positions.

2. Method according to Claim 1, characterized in that when a symbol is received, the code sequence is examined for scalability with all its values and in that, if appropriate, both the interval which is valid in each case and the code sequence are changed in the same scale.

3. Method according to Claim 1 or 2, characterized in that the binary positions following the code sequence, which can no longer be influenced by scaling, are output.

4. Method according to one of Claims 1 to 3, characterized in that, within the last-determined part-interval, the binary permutation with a minimum number of binary positions which is located within the interval is determined.

5. Method according to Claims 1 to 4, characterized in that the code sequence is terminated by an end-of-sequence character.

6. Method according to Claims 1 to 5, characterized in that, by means of statistical analysis of the symbols to be coded, their probabilities of occurrence are determined and these are used for controlling the part-intervals.

7. Method according to Claims 1 to 6, characterized in that, during the statistical analysis, the compound probability is taken into consideration in addition to the simple probability of occurrence.

8. Method for redundancy-reduction coding of data, wherein, from a set of symbols provided for coding, those with a higher probability of occurrence are coded with shorter code words than those with a lower probability of occurrence, characterized in that during the specification of the part-intervals, symbols, which, although they belong to the set of symbols provided for coding, have not occurred within a period to be considered, are not considered, that on the first occurrence of a symbol, an equivalent symbol which is identical for all newly occurring symbols, is coded and that, following the code sequence, a code sequence representing the newly occurring symbol is generated.

9. Method according to Claim 1, characterized in that a device for coding can be supplied with symbols from a number of sources via a multiplexer and that a device for the statistical analysis of the symbols supplies probabilities of occurrence of the symbols of in each case one source to the device for coding.

**Revendications**

1. Procédé de codage avec réduction de redondance selon lequel dans un ensemble de symboles prévu pour le codage, on code ceux ayant la plus grande probabilité d'occurrence avec des mots de code plus courts que ceux ayant une moindre probabilité d'occurrence ; un nombre de symboles qui se produit successivement dans le temps constituant une suite de signaux pour former un intervalle à partir des intervalles partiels qui représentent les probabilités d'occurrence des différents symboles ; et on vérifie dans quel intervalle partiel tombe le symbole respectif à coder ; le point initial de l'intervalle partiel dans lequel tombe chaque fois le symbole à coder forme une suite codée, et d'un symbole à l'autre, l'intervalle partiel dans lequel tombe le symbole est pris comme intervalle principal pour le symbole suivant et on transmet la suite codée générée par le dernier symbole,
caractérisé en ce que
la suite codée formée par le codage de l'ensemble de la suite de symboles présente une valeur qui tombe avec des positions binaires aussi réduites que possible dans l'intervalle partiel déterminé en dernier lieu.

2. Procédé selon la revendication 1,
caractérisé en ce qu'
à l'arrivée d'un symbole, on examine la suite de codes avec toutes ses valeurs pour déterminer la possibilité de transformation scalaire et en cas de concordance, on modirie à la fois l'intervalle respectif valable et la suite codée selon la même échelle.

3. Procédé selon la revendication 1 ou 2,
caractérisé en ce qu'
on émet les positions binaires respectives suivant la suite codée qui ne peuvent plus avoir d'influence par transformation scalaire.

4. Procédé selon l'une quelconque des revendications 1 à 3,
caractérisé en ce qu'
à l'intérieur du dernier intervalle partiel obtenu, on détermine la permutation binaire respective avec le nombre de positions binaires minimum situé dans l'intervalle.

5. Procédé selon les revendications 1 à 4,
caractérisé en ce qu'
on termine la suite codée par un signe de fin.

6. Procédé selon l'une quelconque des revendications 1 à 5,
caractérisé en ce que
par exploitation statistique des symboles à coder, on détermine leurs probabilités d'occurrence, et on commande ainsi les intervalles partiels.

7. Procédé selon les revendications 1 à 6,
caractérisé en ce que
dans l'exploitation statistique, en plus de la simple probabilité d'occurrence, on tient compte de la probabilité composée.

8. Procédé de codage avec réduction de la redondance de données selon lequel dans un ensemble de symboles prévu pour le codage, on code ceux ayant la plus grande probabilité d'occurrence en utilisant des mots de code plus courts que ceux attribués au symbole à probabilité d'occurrence plus faible,
caractérisé en ce qu'
en fixant les intervalles partiels, des symboles qui appartiennent certes à l'ensemble des symboles prévus pour le codage, mais qui ne se sont pas produits dans un intervalle de temps observé, ne sont pas pris en compte et à la première occurrence d'un symbole, on code un symbole de remplacement, égal, qui se produit à la première fois, et en ce qu'en liaison avec la suite codée, on génère une suite codée représentant le symbole produit la première fois.

9. Procédé selon la revendication 1,
caractérisé en ce qu'
une installation de codage reçoit de plusieurs sources des symboles par un multiplexeur et par une installation d'exploitation statistique des symboles appliqués à l'installation pour coder les probabilités d'occurrence des symboles correspondant chaque fois à une source.

Fig. 1

Fig. 2

Fig. 3

aktuelles Intervall

aktuelles Codewort

a)

b)

▦ Einflußbereich

▨ kein Einfluß

▦ Null

Fig. 4

Fig. 5

Fig. 6

**Fig. 7**

**Fig. 10**

Start ⁶²

Neues Symbol ⁶³

Symbol in VDF? ⁶⁴ — JA —→

Symbol „unknown" ──→ Sendebuffer ⁶⁶

Symbol ──→ Sendebuffer ⁶⁵

Symbol ──→ VDF NEUE VDF ⁶⁷

Symbol ──→ Haltebuffer ⁶⁸

NEIN — EOS ? ⁶⁹

Markoff-n-Prozeß Sendebuffer ──→ AC ⁷⁰

Markoff-0 Haltebuffer ──→ AC ⁷¹

Ende oder nächste Quelle ⁷²

Fig. 8

Fig. 9